# DEMANDE DE BREVET EUROPEEN

(11) **EP 1 152 467 A1**
(43) Date de publication de la demande: **07.11.2001**
(21) Numéro de dépôt: 01410044.0
(22) Date de dépôt: 04.05.2001
(51) Int. Cl.: H01L 27/08, H01L 21/761

(54) **Composant monolithique à commande unique pour un pont mixte**

(30) Priorité: 05.05.2000 FR 0005804
(71) Demandeur: STMicroelectronics S.A., 92120 Montrouge (FR)
(72) Inventeur: Galté, Franck, 37270 Veretz (FR); Ladiray, Olivier, 37270 Montlouis sur Loire (FR)
(74) Mandataire: de Beaumont, Michel

(57) **Abrégé**

L'invention concerne un composant monolithique incluant deux thyristors (Th1, Th2) d'un pont mixte connectés à une borne de tension alternative (3) par une métallisation commune de face arrière constituant une électrode de polarité opposée de chaque thyristor. Un mur d'isolement (13) sépare un substrat en deux parties (11, 12), une première partie (11) comprend du côté de sa face inférieure une région d'anode (24) et du côté de sa face supérieure une région de cathode (22), la deuxième partie (12) comprend du côté de sa face inférieure une région de cathode (36) et du côté de sa face supérieure une région d'anode (31). Le mur d'isolement (14, 15) entourant chacun des composants se prolonge en direction de l'électrode principale du côté ne portant pas de métallisation commune et comprend dans cette zone de prolongement une zone de type N (28, 38), ces deux zones étant connectées ensemble à une borne de commande (G).

## Description

La présente invention concerne la réalisation d'un pont redresseur commandé, ou pont mixte.

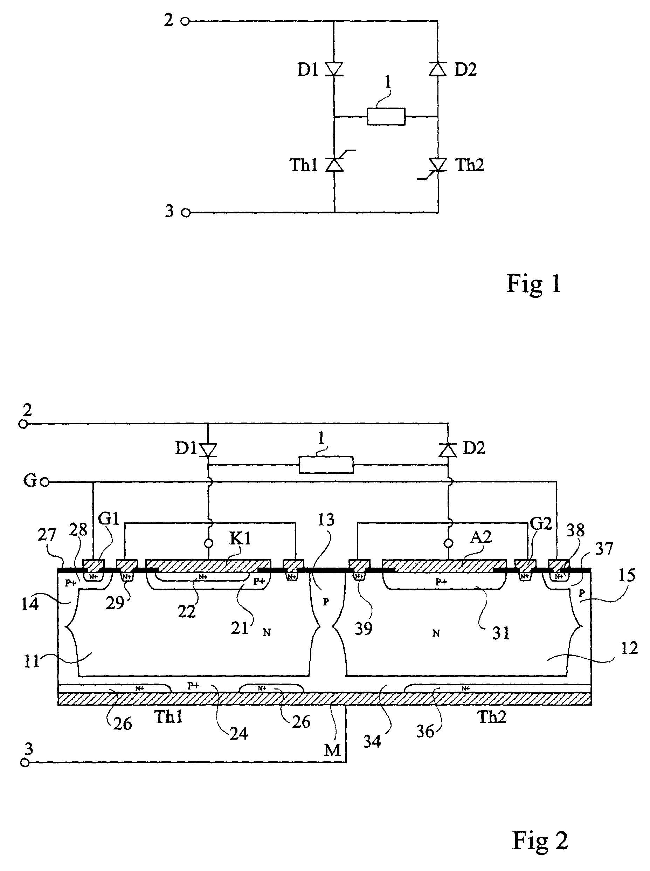

La figure 1 représente le schéma classique d'un pont mixte destiné à alimenter en continu une charge 1. Ce pont est connecté par des bornes 2 et 3 au réseau alternatif, la borne 3 étant considérée comme la borne de référence. A la borne 2 sont connectées l'anode d'une diode D1 et la cathode d'une diode D2. La cathode de la diode D1 et l'anode de la diode D2 sont reliées aux bornes de la charge 1. Un thyristor Th1 est connecté par son anode à la borne 3 et par sa cathode à la cathode de la diode D1. Un thyristor Th2 est connecté par sa cathode à la borne 3 et par son anode à l'anode de la diode D2. Avec un tel pont on peut faire passer un courant redressé dans la charge 1. En outre, on peut réaliser des déclenchements sur des portions d'alternance ; ce qui est couramment appelé commande par angle de phase.

Le pont de la figure 1 présente de nombreux avantages par rapport aux divers autres montages connus de ponts commandés. Par rapport à un pont comprenant deux thyristors en série, il présente l'avantage que les diodes D1 et D2 servent de diodes roue libre pendant les phases où les thyristors Th1 et Th2 sont bloqués. Par rapport à un pont à 4 diodes en série avec un triac, il présente notamment l'avantage que, à la conduction, la chute de tension est réduite de sensiblement la chute de tension d'une diode en direct.

Malgré ces avantages, le montage de la figure 1 est rarement utilisé car il se pose un problème de commande des thyristors. En effet, les thyristors Th1 et Th2 sont commandés par des tensions de gâchette respectivement référencés à leurs cathodes. Or les cathodes des thyristors Th1 et Th2 ne sont pas au même potentiel. Ceci oblige à utiliser des circuits de commande distincts et relativement complexes, et fréquemment des circuits de commande à isolement, l'isolement étant assuré par exemple par un transformateur ou par des composants à commande optique. De plus, dans les circuits connus, les deux thyristors Th1 et Th2 sont généralement réalisés sous forme de composants discrets.

Le brevet américain 5 365 086 de Robert Pezzani, cédé à la demanderesse (B2069) décrit un thyristor dont la cathode correspond à la face arrière du composant revétue d'une métallisation unique connectée à une borne de référence et dont la borne de commande est prise du côté opposé et est référencée à la cathode. On pourrait imaginer d'utiliser ce thyristor pour remplacer le thyristor Th2 de la figure 1. Toutefois, ce brevet ne suggère pas comment associer un thyristor à un thyristor de polarité opposée.

La demande de brevet européen 817 277 au nom de la demanderesse et dont l'inventeur est Robert Pezzani (B3073) décrit un commutateur bidirectionnel (ACS) dont l'électrode de commande est disposée sur la face opposée à une face commune, la tension de commande étant référencée à cette borne commune. Toutefois, ce brevet décrit uniquement un commutateur bidirectionnel à une seule borne de commande et deux électrodes principales seulement et n'indique pas comment réaliser deux thyristors ayant une borne principale commune et leurs autres bornes distinctes.

Ainsi, un objet de la présente invention est de prévoir un composant monolithique correspondant à deux thyristors connectés par l'une de leurs bornes principales de polarité opposée constituant une face du composant, une borne de commande unique permettant d'actionner ces deux thyristors étant disposée sur la face opposée du composant en même temps que l'autre borne principale de chacun des thyristors.

Pour atteindre cet objet, la présente invention prévoit un composant monolithique incluant deux thyristors d'un pont mixte connectés à une borne de tension alternative par une borne commune correspondant à une métallisation commune de face arrière constituant une électrode de polarité opposée de chaque thyristor, comprenant, dans un substrat d'un premier type de conductivité, un mur d'isolement séparant le substrat en deux parties, une première partie comprenant du côté de sa face inférieure une région d'anode et du côté de sa face supérieure une région de cathode, la deuxième partie comprenant du côté de sa face inférieure une région de cathode et du côté de sa face supérieure une région d'anode, le mur d'isolement entourant chacun des composants se prolongeant en direction de l'électrode principale du côté ne portant pas de métallisation commune et comprenant dans cette région de prolongement une zone du deuxième type de conductivité, ces deux zones étant connectées ensemble à une borne de commande commune.

Selon un mode de réalisation de la présente invention, du côté de la face supérieure, la région de gâchette de cathode dans laquelle est comprise la région de cathode d'un premier thyristor est entourée d'un anneau du premier type de conductivité à fort niveau de dopage formé dans le substrat, de même que la région d'anode de l'autre thyristor.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente le schéma de circuit d'un pont mixte ; et
la figure 2 représente un mode de réalisation des deux thyristors du pont mixte dans un mode de réalisation monolithique selon la présente invention.

La figure 2 représente sous forme de schéma de circuit la charge 1 et les diodes D1 et D2 de la figure 1. Les thyristors Th1 et Th2 sont représentés sous forme d'une vue en coupe d'un composant monolithique. Ce composant est réalisé à partir d'un substrat de type N divisé en deux parties 11 et 12 par un mur d'isolement 13 de type P. Dans le mode de réalisation représenté, le mur de séparation 13 fait partie de murs d'isolement respectifs 14 et 15 délimitant chacune des parties du substrat dans lesquelles sont respectivement formés le thyristor Th1 et le thyristor Th2. Du côté de la face arrière est déposée une métallisation commune M qui constitue la métallisation d'anode du thyristor Th1 et la métallisation de cathode du thyristor Th2.

Le thyristor Th1 comprend du côté de la face avant une région 21 de type P dans laquelle est formée une région 22 de type N. La région 22 correspond à la cathode du thyristor Th1 et est revêtue d'une métallisation de cathode K1 reliée à la borne de cathode de la diode D1. Du côté de la face arrière, est formée une couche 24 de type P⁺ et, dans les parties de cette couche P⁺ non disposées en face de la cathode 22, sont formées des régions 26 de type N utiles au déclenchement du thyristor. Du côté de la partie supérieure du mur d'isolement 14 est formée une région 27 également de type P⁺ se prolongeant en direction de la cathode 22. Dans cette région 27 est formée une région 28 de type N revêtue d'une métallisation G1 qui correspond à la gâchette du thyristor Th1.

Le déclenchement du thyristor Th1 peut se produire, quand son anode, la métallisation M de la face arrière, est positive par rapport à la métallisation K1 de face avant, et qu'une tension négative par rapport à la face arrière est appliquée sur la borne de gâchette G. Alors, la jonction entre les régions 28 et 27 est en direct et des électrons venant de la région 28 sont injectés dans la région 27. Il en résulte que des trous sont injectés par la région de type P24 vers les régions 21 et 22, ce qui provoque la mise en conduction du thyristor Th1.

Le thyristor Th2 comprend du côté de sa face avant une région de type P⁺ 31, de préférence formée en même temps que la région 21, qui constitue son anode sur laquelle est formée une métallisation d'anode A2 reliée à l'anode de la diode D2. Du côté de la face arrière, on trouve une région de type P⁺ 34 formée en même temps que la couche 24 et une couche de cathode 36 formée en même temps que la région 26 du thyristor Th1. Du côté de la face avant, le mur d'isolement 15 se prolonge en direction de l'anode par une région de type P 37 dans laquelle est formée une région 38 de type N recouverte d'une métallisation de gâchette G2 reliée à la métallisation de gâchette G1 du thyristor Th1 et à une borne de commande G. Quand le thyristor Th2 est convenablement polarisé, si une impulsion de gâchette est appliquée, la jonction entre la couche 34 et le substrat 12 se débloque et le thyristor Th2 devient conducteur.

On notera que les thyristors Th1 et Th2 sont disposés dans des caissons distincts. Ceci évite que, à la coupure de l'un des thyristors par suite d'une inversion de polarité, l'autre thyristor soit redéclenché par des charges stockées dans des régions voisines de l'autre thyristor. On évite également ainsi le déclenchement d'un thyristor parasite latéral qui correspondrait aux régions P31, N12-11, P21, et N22.

En outre, pour éviter la création de courants de fuite et des déclenchements intempestifs des thyristors, chacune des régions 21 et 31 est entourée d'une région d'arrêt de canal fortement dopée de type N, respectivement 29 et 39.

Par rapport aux divers composants connus, pour la réalisation des éléments commandés d'un pont mixte, ce circuit présente au moins certains des avantages suivants :
- réalisation sous forme d'un composant monolithique ;
- commande par un circuit unique qui peut être un microprocesseur, le circuit de commande étant référencé à la masse ;
- isolement entre les deux thyristors Th1 et Th2, d'où il résulte que l'on évite des mises en conduction parasites ;
- bonne sensibilité.

Bien entendu, la présente invention est susceptible de diverses variantes et modifications qui apparaîtront à l'homme de l'art qui saura dimensionner les diverses couches en fonction des courants prévus. En outre, on notera que les diodes D1 et D2 peuvent éventuellement être intégrées dans le même composant que les deux thyristors commandés décrits précédemment, ces diodes étant réalisées dans des caissons isolés.

La présente invention s'appliquera par exemple dans le domaine de l'électroménager à la commande d'électro-aimants ou à la commande de moteurs universels. Dans les deux cas, l'utilisation d'un pont mixte du type décrit précédemment présente un avantage du fait que les diodes D1 et D2 peuvent fonctionner en roue libre sur charge inductive au moment du blocage de l'un ou l'autre des thyristors.

## Revendications

1. Composant monolithique incluant deux thyristors (Th1, Th2) d'un pont mixte connectés à une borne de tension alternative (3) par une borne commune correspondant à une métallisation commune de face arrière constituant une électrode de polarité opposée de chaque thyristor, **caractérisé en ce qu'**il comprend, dans un substrat d'un premier type de conductivité, un mur d'isolement (13) séparant le substrat en deux parties (11, 12), une première partie (11) comprenant du côté de sa face inférieure une région d'anode (24) et du côté de sa face supérieure une région de cathode (22), la deuxième partie (12) comprenant du côté de sa face inférieure une région de cathode (36) et du côté de sa face supérieure une région d'anode (31), le mur d'isolement (14, 15) entourant chacun des composants se prolongeant en direction de l'électrode principale du côté ne portant pas de métallisation commune et comprenant dans cette zone de prolongement une zone du deuxième type de conductivité (28, 38), ces deux zones étant connectées ensemble à une borne de commande commune (G).

2. Composant selon la revendication 1, **caractérisé en ce que**, du côté de la face supérieure, la région de gâchette de cathode (21) dans laquelle est comprise la région de cathode (22) d'un premier thyristor est entourée d'un anneau (29) du premier type de conductivité à fort niveau de dopage formé dans le substrat, de même que la région d'anode (31) de l'autre thyristor.
